(19)

Europäisches
Patentamt
European
Patent Office
Office européen
des brevets

(11) **EP 2 405 502 A1**

(12) **EUROPEAN PATENT APPLICATION**
published in accordance with Art. 153(4) EPC

(43) Date of publication:
**11.01.2012 Bulletin 2012/02**

(21) Application number: **10748644.1**

(22) Date of filing: **24.02.2010**

(51) Int Cl.:
*H01L 35/32* (2006.01)    *H01L 35/08* (2006.01)
*H01L 35/14* (2006.01)    *H01L 35/34* (2006.01)
*H02N 11/00* (2006.01)

(86) International application number:
**PCT/JP2010/052824**

(87) International publication number:
**WO 2010/101049 (10.09.2010 Gazette 2010/36)**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority:  **03.03.2009  JP 2009049084**

(71) Applicants:
• **Tokyo University Of Science
  Educational Foundation Administrative
  Organization
  Shinjuku-ku
  Tokyo 162-8601 (JP)**
• **Nippon Thermostat Co., Ltd.
  Kiyose-shi
  Tokyo 204-0003 (JP)**

(72) Inventors:
• **IIDA, Tsutomu
  Tokyo 162-8601 (JP)**
• **OGUNI, Yohei
  Tokyo 162-8601 (JP)**
• **NEMOTO, Takashi
  Kiyose-shi
  Tokyo 204-0003 (JP)**
• **SATO, Junichi
  Kiyose-shi
  Tokyo 204-0003 (JP)**

(74) Representative: **Hofmann, Ralf U. et al
Egelseestrasse 65a
Postfach 61
6806 Feldkirch (AT)**

(54) **THERMOELECTRIC CONVERSION ELEMENT AND THERMOELECTRIC CONVERSION MODULE**

(57)     Provided is a thermoelectric conversion element which enables improvement in yield and durability, is easy to secure a temperature difference between the both ends and is easy to be bonded to an electrode without tilting, resulting in improvement of mass productivity. Also provided is a thermoelectric conversion module using the thermoelectric conversion element.

    [Solution] A thermoelectric conversion element 2 includes: a plurality of pole-shaped parts 22 with one ends of which being electrically connected to a first electrode 32, and the pole-shaped-parts 22 being arranged at an interval from each other; and a joining / connecting part 21 joining / connecting the other ends of the pole-shaped parts 22 together, and electrically connected to a second electrode 31. A connecting face 21b of the joining / connecting part 21, the face being connected to the second electrode 31, is larger than the sum total of areas of one ends 22a of the pole-shaped parts 22.

FIG.1

## Description

Technical Field

The present invention relates to a thermoelectric conversion module which performs electric power generation using Seebeck effect or carries out cooling and heating using Peltier effect, and a thermoelectric conversion element used therein.

Background Art

Conventionally, a plurality of n-type thermoelectric conversion elements, which are arranged between both electrodes of a thermoelectric conversion module comprising a pair of substrates and a pair of electrodes provided on respective opposing surfaces of the substrates, and in which one end of each of the n-type thermoelectric conversion elements is electrically connected to one of the electrodes and the other end of each of the n-type thermoelectric conversion elements is connected to the other one of the electrodes, are known (refer to Japanese Patent Laid-Open No. 11-274578, for example).

According to one described in Japanese Patent Laid-Open No. 11-274578, a thermoelectric conversion module in which it is not necessary to arrange electrodes on substrates in a manner of being sectionalized into a plurality of regions to connect p-type and n-type thermoelectric conversion elements alternately and serially, and thus which is easy to be manufactured and has excellent mass productivity can be obtained. Because n-type thermoelectric conversion elements are arranged in parallel, it can have such a fail-safe function that, even if some of the thermoelectric conversion elements are damaged, thermoelectric conversion can be performed by the thermoelectric conversion module as a whole, and the yield and durability can be improved.

Summary of Invention

Technical Problem

The above thermoelectric conversion element can obtain electric power when a temperature difference is applied between its both ends. Therefore, obtaining electric power from waste heat using a thermoelectric conversion element is conceivable. As above, when a thermoelectric conversion element is used in electric power generation, it is necessary to maintain the temperature difference between the both ends of the thermoelectric conversion element properly.

When used in electric power generation, although, in each of thermoelectric conversion element of a conventional thermoelectric conversion module, an amount of absorption of heat in the high temperature side and an amount of heat release in the low temperature side are the same because its area in the high temperature side and its area in the low temperature side are the same, it is desired to make it easy to secure a temperature difference between the both ends of a thermoelectric conversion element by making an amount of heat release in the low temperature side large.

In addition, because thermoelectric conversion elements are bonded to an electrode one by one by soldering such as solder joint and brazing, each of the thermoelectric conversion elements is easy to be tilted against an electrode. When a thermoelectric conversion element tilts, there is a risk that, due to thermal expansion of the element itself, the thermoelectric conversion element will break away from the electrode or a crack will occur in the thermoelectric conversion element. Accordingly, a conventional thermoelectric conversion element has such a problem that a yield is poor and durability is low.

Further, because thermoelectric conversion elements are bonded to an electrode one by one, there is such a problem that manufacturing of a thermoelectric conversion module is time consuming and its mass productivity is low.

In view of the above points, an obj ect of the present invention is to provide a thermoelectric conversion element, which enables to improve a yield and durability, which is easy to secure a temperature difference between the both ends, and which is easy to be bonded to an electrode without tilt resulting in improvement of mass productivity, and a thermoelectric conversion module using the thermoelectric conversion element

Solution to Problem

According to the present invention, a thermoelectric conversion element, arranged between a first electrode and a second electrode of a thermoelectric conversion module comprising the first electrode and the second electrode arranged at an interval from each other, and electrically connecting the first electrode and the second electrode, comprises: a plurality of pole-shaped parts, the pole-shaped parts being arranged at an interval from each other, and one end of each of the pole-shaped parts being electrically connected to the first electrode; and a joining / connecting part joining / connecting the other ends ofthe pole-shaped parts together and electrically connected to the second electrode, wherein a connecting face of the joining / connecting part, the face being connected to the second electrode, is larger than the sum total of areas of the one ends of the respective pole-shaped parts.

According to the present invention, because a thermoelectric conversion element has a plurality of pole-shaped parts, even if some of the pole-shaped parts are damaged, the first electrode and the second electrode can maintain the electrically connected state by other pole-shaped parts, and by this, thermoelectric conversion can be performed, and thus it has a so-called fail-safe function. For this reason, when a thermoelectric conversion module is manufactured using a thermoelectric conversion element of the present invention, the yield of the thermoelectric conversion module can be improved and durability can be also improved.

Also, because the connecting face of the joining / connecting part electrically connected with the second electrode is larger than the sum total of areas of the one ends of the respective pole-shaped parts, in a thermoelectric conversion element according to the present invention, even in the case where the pole-shaped part side is arranged in the high temperature side and the joining / connecting part side is arranged in the low temperature side and it is used in electric power generation, an amount of heat release in the side of the connecting face of the joining / connecting part becomes larger than an amount of absorption of heat in the side of the one ends of the pole-shaped parts, enabling a temperature difference between the both ends to be maintained well and electric power generation to be performed well.

In addition, when the size of each of the pole-shaped parts is made be the same size as that of a conventional thermoelectric conversion element, because each of the pole-shaped parts is joined together by the joining / connecting part, it is as though a plurality of conventional thermoelectric conversion elements are attached to the electrode at one time, and thus mass productivity of the thermoelectric conversion module improves.

Further, at the time of bonding the joining / connecting part of a thermoelectric conversion element to the second electrode, because the contact area of the joining / connecting part becomes larger than the contact area of a conventional thermoelectric conversion element, it becomes easy to bond the thermoelectric conversion element to the second electrode without a tilt. By this, occurrence of a crack and rupture of the thermoelectric conversion element due to a tilt of the thermoelectric conversion element against the second electrode described above can be prevented, resulting in improvement of durability of the thermoelectric conversion element. Also, because the bonded area between the joining / connecting part and the second electrode becomes large, it is possible to improve a bonding strength between them and to reduce the risk that the thermoelectric conversion element will break away from the second electrode.

When the section area of each of the pole-shaped parts of a thermoelectric conversion element of the present invention is made be the same as that of a conventional thermoelectric conversion element and the length of the thermoelectric conversion element of the present invention in the direction from one electrode to the other electrode is made be the same as that of the conventional thermoelectric conversion element, because the contact area of the joining / connecting part bonded to the second electrode of the thermoelectric conversion element of the present invention becomes larger than the area of the conventional thermoelectric conversion element bonded to the second electrode, the internal resistance of the thermoelectric conversion element itself and the electrical resistance of the bonded portion between the thermoelectric conversion element and the second electrode can be suppressed to be small, and thus electric power can advantageously be taken out easily.

In a thermoelectric conversion element of the present invention, when the area of the one end of each of the pole-shaped parts is made smaller than the section area of the connecting portion between each of the pole-shaped parts and the joining / connecting part, absorption of heat of the thermoelectric conversion element in the one ends of the pole-shaped parts can be suppressed further, and thus a large temperature difference can be more easily secured, resulting in effective electric power generation.

In a thermoelectric conversion module, comprising a plurality of thermoelectric conversion elements according to the present invention arranged between a pair of substrates in a state of being electrically connected to the first electrode and the second electrode, and all of the thermoelectric conversion elements being formed as n-type or p-type, when it is composed such that the first electrode connected to one thermoelectric conversion element is electrically connected to the second electrode connected to an adjacent thermoelectric conversion element to connect each of the thermoelectric conversion elements in series, it is possible to produce a thermoelectric conversion module of various output characteristics, using a thermoelectric conversion element of one type as a unit element, according to application of the thermoelectric conversion module, while securing the fail-safe function, and according to a required voltage and current so as to improve the general versatility.

When a heat-insulating material is arranged between a pair of substrates of a thermoelectric conversion module, because heat transmission between the substrates due to radiation heat is blocked and heat release between the substrates is prevented, a temperature difference between the both substrates can be secured more properly.

In a thermoelectric conversion module, comprising a plurality of thermoelectric conversion elements according to the present invention, the thermoelectric conversion elements being formed as n-type and p-type and arranged between a pair of substrates in a state of the thermoelectric conversion elements being connected to the first electrode and the second electrode in a manner that n-type thermoelectric conversion elements and p-type thermoelectric conversion elements are positioned alternately, when it is composed such that the first electrodes of two adjacent thermoelectric conversion elements are electrically connected to each other, and the second electrodes of the two adjacent thermoelectric conversion elements having the first electrodes separated from each other are electrically connected with each other, resulting in each of the thermoelectric conversion elements being connected in series, even when a thermoelectric conversion element is formed by a material through which electric power cannot be taken out sufficiently when using only either n-type ones or p-type ones, sufficient electric power can be taken out.

Brief Description of Drawings

[Figure 1] Figure 1 is an explanatory diagram showing a thermoelectric conversion module of a first embodiment using a thermoelectric conversion element of the present invention.
[Figure 2] Figure 2 is a perspective view showing a thermoelectric conversion element of the first embodiment.
[Figure 3] Figure 3 is an explanatory diagram showing a thermoelectric conversion module of a second embodiment using a thermoelectric conversion element of the present invention.
[Figure 4] Figure 4 is an explanatory diagram showing a thermoelectric conversion module of a third embodiment using a thermoelectric conversion element of the present invention.
[Figure 5] Figure 5 (a) is a pattern diagram of the thermoelectric conversion module of the first embodiment and its equivalent circuit schematic. Figure 5 (b) is a pattern diagram of a comparative example and its equivalent circuit schematic.
[Figure 6] Figure 6 is an explanatory diagram showing a thermoelectric conversion module of a fourth embodiment using a thermoelectric conversion element of the present invention.
[Figure 7] Figure 7 is an explanatory diagram showing a manufacturing method of the thermoelectric conversion element of the first embodiment.
[Figure 8] Figure 8 is an explanatory diagram showing a manufacturing method of the thermoelectric conversion element of the first embodiment.
[Figure 9] Figure 9 is an explanatory diagram showing the relation between a temperature and a Seebeck coefficient in a material of the thermoelectric conversion element of the first embodiment.
[Figure 10] Figure 10 is an explanatory diagram showing the relation between a temperature and electric conductivity in the material of the thermoelectric conversion element of the first embodiment.
[Figure 11] Figure 11 is an explanatory diagram showing the relation between a temperature and an electric power factor in the material of the thermoelectric conversion element of the first embodiment.
[Figure 12] Figure 12 is an explanatory diagram showing the relation between a temperature and thermal conductivity in the material of the thermoelectric conversion element of the first embodiment.
[Figure 13] Figure 13 is an explanatory diagram showing the relation between a temperature and a dimensionless performance index in the material of the thermoelectric conversion element of the first embodiment.
[Figure 14] Figure 14 is a perspective view showing the thermoelectric conversion module of the first embodiment.
[Figure 15] Figure 15 is a perspective view showing a thermoelectric conversion element module of a comparative example.
[Figure 16] Figure 16 is an explanatory diagram showing the relation between a temperature difference and electric power (output) in the thermoelectric conversion module of the first embodiment.

Description of Embodiments

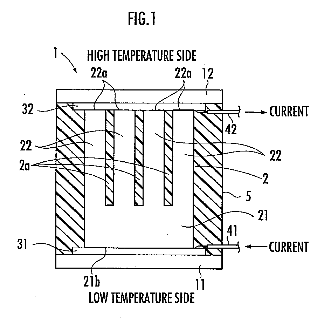

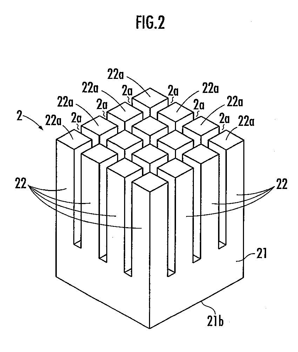

Referring to Figure 1 and Figure 2, a thermoelectric conversion module using a thermoelectric conversion element of a first embodiment of the present invention for use in electric power generation will be described. A thermoelectric conversion module 1 of the first embodiment comprises: a pair of substrates 11 and 12, being formed by aluminum oxide and having insulation properties; first and second electrodes 31 and 32 made of a copper sheet arranged on each of the opposed surfaces of the substrates 11 and 12; and an n-type thermoelectric conversion element 2 made of $Mg_2Si$ and arranged between both the electrodes 31 and 32.

Although, BiTe, PbTe and CoSb is used as a material of a thermoelectric conversion element conventionally, all of them have hazardous properties for a human body (including ones whose hazardous properties are concerned) and are expensive. $Mg_2Si$ is harmless for a human body, its environmental burden is small, its stock is large, and it is inexpensive. Also, because its relative density is light, it can form the thermoelectric conversion element 2 that is very lightweight. For this reason, in recent years, $Mg_2Si$ has been attracting notice as a material of a thermoelectric conversion element.

Meanwhile, the substrates 11 and 12 are not limited to aluminum oxide, and may be formed by other materials. Each of the electrodes 31 and 32 may be provided on the substrates 11 and 12 in the form of thin film. The electrodes 31 and 32 are not limited to copper, and one of another material may be used.

The thermoelectric conversion element 2 includes: a plurality of square-pole-shaped parts 22, one end 22a of each of the square-pole-shaped parts 22 being bonded with the first electrode 32; and a joining / connecting part 21 of a rectangular plate shape for joining / connecting other ends of the square-pole-shaped parts 22 together, and has a pinholder shape. The joining / connecting part 21 is bonded to the second electrode 31. Soldering and brazing or adhesion by an electrically conductive adhesive such as silver paste can be used as a bonding method, and bonding is made by appropriately selecting such methods according to application and the like of a thermoelectric conversion module.

When bonding is made by soldering and brazing, a brazing filler metal (solder) may be pasted on the both ends of the thermoelectric conversion element 2 in advance. Although the surface of the thermoelectric conversion element 2 is a face having small irregularities, it can be made be a smooth face by covering the irregularities on the surface with a brazing filler metal (solder), silver past or the like. By this, a bonding state between the thermoelectric conversion element 2 and the electrodes 31 and 32 is improved and excellent conductivity can be secured. To the electrode 31, a lead wire 41 is soldered/ brazed. To the electrode 32, a lead wire 42 is soldered/ brazed.

A heat-insulating material 5 is arranged between the substrates 11 and 12 of the thermoelectric conversion module 1. Because, by this, heat transmission between the substrates 11 and 12 by radiation heat is blocked, and heat release between the substrates 11 and 12 is prevented, a temperature difference between the both substrates 11 and 12 is secured more properly. Meanwhile, as the heat-insulating material 5, although it is preferred to use a porous body of oxide silicon or alumina, other materials may be used.

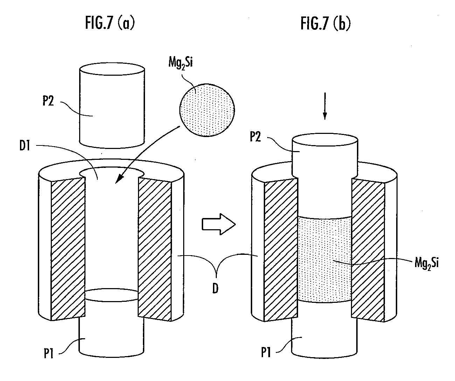

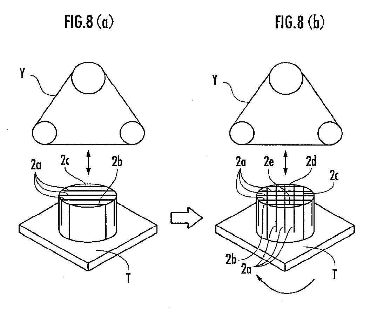

Next, with reference to Figures 7 and 8, a manufacturing method of the thermoelectric conversion element 2 of the first embodiment will be described. First, as shown in Figure 7, in the state that the lower opening of a mold D having a through-hole D1 of a columnar-shape through it in the up and down directions is closed by inserting a punch P1 into the through-hole D1, $Mg_2Si$ in powder form (mean particle diameter of about 63 $\mu$m) is fed into the through-hole D1 of the mold D from the upper opening.

Then, $Mg_2Si$ of powder form is pressed by inserting a punch P2 from the upper opening of the through-hole D1, and, after changing to an argon atmosphere (argon pressure of 0.06 MPa) in order to prevent blowout of the $Mg_2Si$ in powder form, sintering processing is performed under four gradual sintering conditions of: the first step of increasing temperature from the room temperature to 500°C by spending 5 min; the second step of increasing temperature from 500°C to 700°C by spending 4 min; the third step of increasing temperature from 700°C to 750°C by spending 5 min; and the fourth step of increasing temperature from 750°C to 775°C by spending 2 min. The size of an obtained sintered body is 15 mm in diameter and 10 mm in height. Meanwhile, although the sintering temperature is appropriately selected according to a compositional ratio and the like, it can be performed in the range of 700-950°C generally.

Next, as shown in Figure 8, the obtained sintered body is placed on a rotating table T, and by moving a wire saw Y up and down, a first cut section 2b, three trenches 2a, 2a and 2a, a second cut section 2c are formed in this order in the direction from the front side of the drawing toward the back side of the drawing having an interval from each other. Then, after turning the sintered body by 90 degrees by turning the rotating table T, a third cut section 2d, three trenches 2a, 2a and 2a, a fourth cut section 2e are formed in this order in the direction from the front side of the drawing toward the back side of the drawing having an interval from each other. In this manner, the thermoelectric conversion element 2 shown in Figure 2 is formed.

Meanwhile, the method to form the trench 2a and the cut sections 2b-2e is not limited to the wire saw Y, and a blade saw and a micro blast and the like can be also used, for example.

In addition, the manufacturing method of the thermoelectric conversion element 2 is not limited to this, and other method may be used. For example, $Mg_2Si$ in powder form may be fed into a pinholder-shaped mold and then sintered, or injection molding may be used. When the thermoelectric conversion element 2 is formed by injection molding, melted $Mg_2Si$ may be cast into a pinholder-shaped mold.

Although, as the thermoelectric conversion element 2 of the first embodiment, one having a square-pole shape has been shown in Figure 2, it is not limited to this, and it may be of another shape such as a columnar shape. In the case where the thermoelectric conversion element 2 is formed into a columnar shape, it is obtained by forming the trench 2a using a columnar-shaped mold, for example, instead of the first to fourth above-mentioned four cut sections 2b-2e.

The number of the pole-shaped parts 22 and its height, the width of the trench 2a and the size and thickness of the joining / connecting part 21 are selected appropriately with the view of securing a temperature difference of the thermoelectric conversion element 2, radiation heat from the high temperature side, thermal conduction, and mechanical strength of the thermoelectric conversion element 2 itself and the like.

Next, operation of the thermoelectric conversion module 1 of the first embodiment will be described. When the substrate 12 of the thermoelectric conversion module 1 is attached to a heat source and the substrate 11 is cooled, a temperature difference occurs between the both ends of the thermoelectric conversion element 2 and a current is flowed by Seebeck effect, causing electric power generation. On this occasion, in order to continue electric power generation, it is necessary to keep maintaining a predetermined temperature difference between the both ends of the thermoelectric conversion element 2. According to the first embodiment, because $Mg_2Si$ that has small thermal conductivity is used as a material of the thermoelectric conversion element 2, a temperature difference can be maintained well.

In addition, the thermoelectric conversion element 2 of the first embodiment is one in which the lattice-like trench 2a is formed in a block body whose cross section is of rectangular shape, and thus the area of the other face 21b contacting with the electrode 31 of the joining / connecting part 21 is larger than the sum total of areas of the one ends 22a of the respective pole-shaped parts 22. For this reason, in the thermoelectric conversion element 2, due to its shape, absorption of heat is suppressed at its end in the high temperature side and heat release is facilitated at its end in the low temperature side, enabling a temperature difference between the both ends to be maintained more properly.

According to the thermoelectric conversion module 1 using the thermoelectric conversion element 2 of the first embodiment, because the thermoelectric conversion element 2 comprises a plurality of the pole-shaped parts 22, even if some of the pole-shaped parts 22 are damaged, the first electrode 32 and the second electrode 31 can maintain the electrically connected state by other pole-shaped parts 22, and by this, thermoelectric conversion can be performed. For this reason, according to the thermoelectric conversion module 1 of the first embodiment, it is possible to improve a yield and durability.

Also, because the connecting face 21b of the joining / connecting part 21 electrically connected with the second electrode 31 is larger than the sum total of areas of the one ends 22a of the pole-shaped parts 22, in the thermoelectric conversion element 2, an amount of heat release in the side of the connecting face 21b of the joining / connecting part 21 becomes larger than an amount of absorption of heat in the side of the one end 22a of the pole-shaped parts 22, enabling a temperature difference between the both ends to be maintained well and electric power to be generated well.

In addition, when the size of each of the pole-shaped parts 22 is made be the same size as that of a conventional thermoelectric conversion element, because each of the pole-shaped parts 22 is joined together by the joining / connecting part 21, it is as though a plurality of conventional thermoelectric conversion elements are attached to the second electrode at one time, and thus mass productivity of the thermoelectric conversion module 1 is improved.

Further, the connecting face 21b of the joining / connecting part 21 electrically connected to the second electrode 31 becomes larger than the sum total area of faces of conventional thermoelectric conversion elements electrically connected to the second electrode by an area corresponding to the trench 2a. Accordingly, it becomes easy to bond the thermoelectric conversion element 2 to the second electrode 31 without tilt.

By this, occurrence of a crack and rupture of the thermoelectric conversion element 2 due to a tilt of the thermoelectric conversion element 2 against the second electrode 31 can be prevented, resulting in improvement of durability of the thermoelectric conversion element 2. Also, because the bonded area between the joining / connecting part 21 and the second electrode 31 becomes large, it is possible to improve a bonding strength between them and to reduce the risk that the thermoelectric conversion element 2 will break away from the second electrode 31.

Further, a thermoelectric conversion element is very fragile generally, and when one having a block body left as it is without the trench 2a formed in it, for example, is used as a thermoelectric conversion element, once a clack is formed, there is the risk that the whole element will be ruptured easily. On the contrary, because the thermoelectric conversion element 2 of the first embodiment has a plurality of the pole-shaped parts 22, even if a crack occurs in one of the pole-shaped parts 22, the others of the pole-shaped parts 22 are not influenced by the crack. Accordingly, the thermoelectric conversion element 2 of the first embodiment has improved durability compared to a conventional thermoelectric conversion element.

Also, because the contact area of the joining / connecting part 21 bonded to the second electrode 31 is large, the internal resistance of the thermoelectric conversion element 2 and the electrical resistance of the bonded portion between the thermoelectric conversion element 2 and the second electrode 31 can be suppressed to be small and thus electric power can be easily taken out.

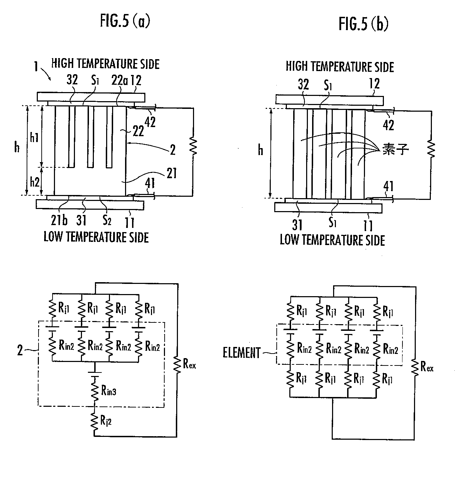

This will be described using the pattern diagram and the equivalent circuit schematic of Figure 5. The upper diagram of Figure 5(a) is a pattern diagram showing the thermoelectric conversion module 1 of the first embodiment as a module comprising the four pole-shaped parts 22, and the lower diagram of Figure 5(a) shows an equivalent circuit of the upper diagram. $R_{ex}$ of the equivalent circuit indicates a load resistance. Assuming that: the internal resistance of the thermoelectric conversion element 2 is $R_2$; the internal resistance of one of the pole-shaped parts 22 is $R_{in2}$; the height of the pole-shaped parts 22 is $h_1$; the area of the one end 22a of each of the pole-shaped parts 22 is $S_1$; the internal resistance of the joining / connecting part 21 is $R_{in3}$; the height of the joining / connecting part 21 is $h_2$; the area of the connecting face 21b of the joining / connecting part 21 is $S_2$; and the electric resistivity of $Mg_2Si$ is p, internal resistance $R_2$ of the thermoelectric conversion element 2 is obtained from the following formula (1).

$$R_2 = R_{in2} / 4 + R_{in3} = \rho \left( h_1 / 4S_1 + h_2 / S_2 \right) \dots (1)$$

In Figure 5(b), a pattern diagram of a comparative example is shown in the upper diagram, and its equivalent circuit is indicated in the lower diagram. The thermoelectric conversion element of the comparative example is formed by $Mg_2Si$, and four elements each having the same section area as the section area $S_1$ of the pole-shaped parts 22 of the first embodiment and the same height as the height h ($h = h_1 + h_2$) of the thermoelectric conversion element 2 of the first embodiment are arranged between the electrodes. Assuming that: the internal resistance of a thermoelectric conversion element of the comparative example is $R_{in1}$; and the sum total of the internal resistances of the four thermoelectric conversion elements is $R_1$, $R_1$, is obtained from the following formula (2).

$$R_1 = R_{in1} / 4 = \rho \, (h_1 + h_2) / (4S_1) \dots (2)$$

When, in order to compare the internal resistance $R_2$ of the thermoelectric conversion element 2 of the first embodiment and the sum total $R_1$ of the internal resistances of the four thermoelectric conversion elements of the comparative example, $R_2$ is subtracted from $R_1$, the following formula (3) will be obtained from formulas (1) and (2).

$$R_1 - R_2 = \{\rho h_2 \, (S_2 - 4S_1)\} / (4S_1 S_2) \dots (3)$$

Here, the area $S_2$ of the contact face 21b of the joining / connecting part 21 is larger than $4S_1$ that is the sum total of the one ends 22a of the respective pole-shaped parts 22 by an area corresponding to the interval between the pole-shaped parts 22. Accordingly, $(S_2 - 4S_1) > 0$ holds, and thus formula (3) also becomes a value exceeding 0. Therefore, it can be found that the internal resistance of the thermoelectric conversion element 2 of the first embodiment is smaller than that of the four thermoelectric conversion elements of the comparative example.

Next, contact resistance of the connecting portion of the thermoelectric conversion element 2 of the first embodiment with the electrodes 31 and 32 in Figure 5 (a) will be considered. Assuming that: the sum total of contact resistances of the connecting portions of the thermoelectric conversion element 2 of the first embodiment with the electrodes 31 and 32 is $R_a$; the contact resistance of the connecting portion of the one end 22a of one of the pole-shaped parts 22 with the first electrode 32 is $R_{j1}$; the contact resistance of the connecting portion of the connecting face 21b of the joining / connecting part 21 with the second electrode 31 is $R_{j2}$; the electric resistivity of the connecting portions is $\rho'$; and the thickness of the connecting portions is $h_s$ (it is assumed that all of the bonded portions have a uniform bonding state and a uniform thickness); $R_a$ is obtained by the following formula (4).

$$R_a = R_{j1} / 4 + R_{j2} = \rho' \, (h_s / 4S_1 + h_s / S_2) \dots (4)$$

When the contact resistance of the connecting portions of the four thermoelectric conversion elements of the comparative example shown in Figure 5 (b) with the electrodes 31 and 32 is considered, and when assuming that the sum total of the contact resistances of the connecting portions of the four thermoelectric conversion elements of the comparative example with the electrodes 31 and 32 is $R_b$, the contact resistance of each end of one of the thermoelectric conversion elements of the comparative example becomes $R_{j1}$ because its area is the same as that of the one end 22a of each of the pole-shaped parts 22. Accordingly, $R_b$ is obtained by the following formula (5).

$$R_b = R_{j1} / 4 + R_{j1} / 4 = R_{j1} / 2 = \rho' h_s / 2S_1 \dots (5)$$

When, in order to compare the contact resistance $R_a$ of the thermoelectric conversion element 2 of the first embodiment and the sum total $R_b$ of the contact resistances of the four thermoelectric conversion elements of the comparative example, $R_a$ is subtracted from $R_b$, the following formula (6) will be obtained from formulas (4) and (5).

$$R_b - R_a = \rho' h_s \, (S_2 - 4S_1) / (4S_1 S_2) \dots (6)$$

Here, the area $S_2$ of the contact face 21b of the joining / connecting part 21 is larger than $4S_1$ that is the sum total of the one ends 22a of the respective pole-shaped parts 22 by an area corresponding to the interval between the pole-shaped parts 22. Accordingly, $(S_2 - 4S_1) > 0$ holds, and thus formula (6) also becomes a value exceeding 0. Therefore, it is found that the contact resistance of the thermoelectric conversion element 2 of the first embodiment is smaller than that of the four thermoelectric conversion elements of the comparative example.

As described above, because the thermoelectric conversion element 2 of the first embodiment has a small internal resistance and a small contact resistance and thus the electrical loss is small compared with the four thermoelectric conversion elements of the comparative example, electric power that is larger than that of the comparative example can be obtained.

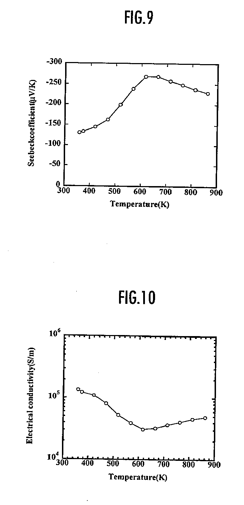

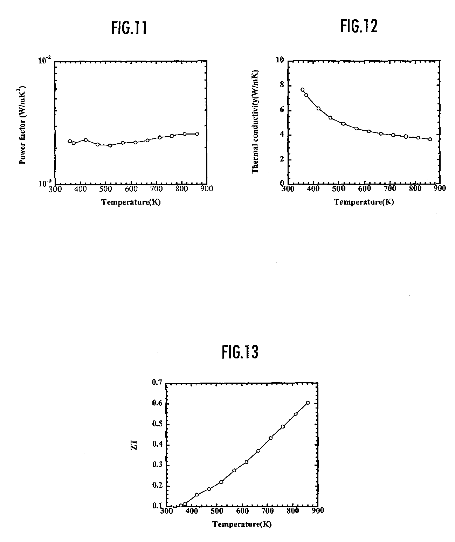

In order to confirm thermoelectric conversion performance of the $Mg_2Si$ material, a Seebeck coefficient, electric conductivity and an electric power factor (Power Factor) were measured by means of a steady current method using a sintered body of 4 mm$^2$ in section area and 8 mm in height having a square cross sectional shape. As thermoelectric characteristic evaluation equipment, ZEM-2 manufactured by ULVAC-RIKO Inc. was used. The relation between temperature and a Seebeck coefficient is shown in Figure 9, the relation between temperature and electric conductivity in Figure 10 and the relation between temperature and an electric power factor in Figure 11, respectively.

The thermal conductivity of the above thermoelectric module 1 was measured using TC-7000H manufactured by ULVAC-RIKO Inc. The relation between temperature and thermal conductivity is shown in Figure 12.

A dimensionless performance index ZT that will be an index of performance of a thermoelectric conversion material was calculated using the Seebeck coefficient, electric conductivity and thermal conductivity that had been obtained by the above measurement The relation between temperature and a dimensionless performance index ZT is shown in Figure 13. As can be seen from Figure 13, regarding the dimensionless performance index ZT, a good thermoelectric characteristic of ZT = 0.6 is obtained at 873 K.

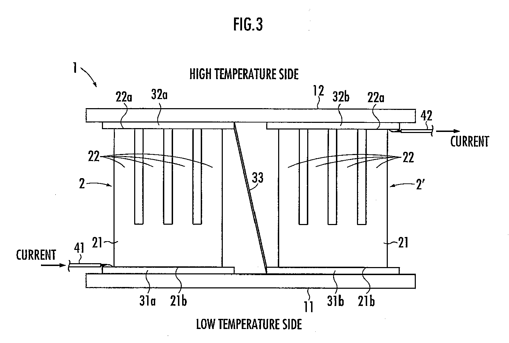

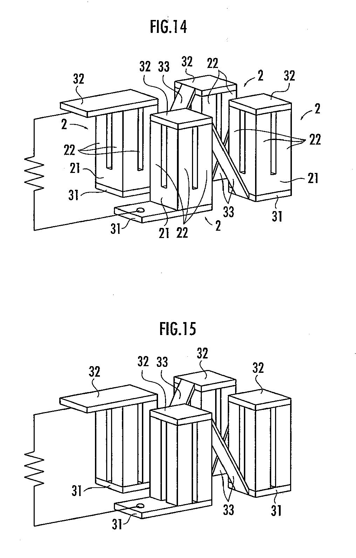

Next, using the thermoelectric conversion module 1 in which the four pieces of the thermoelectric conversion elements 2 each comprising the four pole-shaped parts 22 as shown in Figure 14 are connected serially as is the case with the thermoelectric conversion module 1 of Figure 3, electric power obtained at a predetermined temperature difference was measured by thermoelectric characteristic evaluation equipment UMTE-1000M manufactured by Union Material Co., Ltd. Meanwhile, the thermoelectric conversion module 1 shown in Figure 14 is indicated in a manner that the substrates 11 and 12 are omitted.

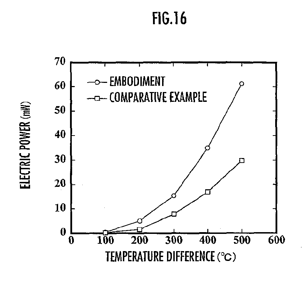

In this measurement, it was arranged such that: the temperature of the substrate 11 in the low temperature side was 100°C and the temperature of the substrate 12 in the high temperature side was 200°C-600°C; the section area and the height of each of the pole-shaped parts 22 were 4 mm$^2$ and 7 mm; the width of the trench 2a was 0.3 mm; the height, width and depth of the joining / connecting part 21 were 3 mm, 4.3 mm and 4.3 mm; and the height of each of the thermoelectric conversion elements 2 was 10 mm. As a comparative example, regarding a thermoelectric conversion module in which, as shown in Figure 15, four units were connected in series between the substrates 11 and 12, each of the units being formed by arranging four thermoelectric conversion elements of a 4 mm$^2$ cross section and 10 mm height in parallel between the electrodes 31 and 32 at intervals of 0.3 mm, measurement of electric power was performed by the similar method. Meanwhile, the thermoelectric conversion module of the comparative example shown in Figure 15 is indicated in a manner that the substrates 11 and 12 are omitted. The relation between a temperature difference and electric power (output) is shown in Figure 16. As can be seen from Figure 16, it is found that the thermoelectric conversion element 2 of the first embodiment can obtain electric power of about two times as large as that of the comparative example.

According to the thermoelectric conversion module 1 of the first embodiment, because all of the pole-shaped parts 22 electrically connected to the first electrode 32 are joined together by the joining / connecting part 21 electrically connected to the substrate 11, the mechanical strength of the substrate 11 side of the thermoelectric conversion element 2 can be improved dramatically in comparison with a conventional one in which a plurality of thermoelectric conversion elements are arranged between a pair of electrodes at an interval from each other. In addition, because the mechanical strength of the substrate 11 side of the thermoelectric conversion element 2 is improved, the substrate 11 requires just smaller mechanical strength than before, and the production cost can be suppressed to be low by forming the substrate 11 using an inexpensive material with low stiffness or by making it thinner.

Meanwhile, although in the first embodiment, the thermoelectric conversion element 2 is formed by Mg$_2$Si, it is not limited to this. Any kinds of thermoelectric conversion materials such as: Bi-Te family including Sb-Te family and Bi-Se family; Pb-Te family including Sn-Te family and Ge-Te family; Ag-Sb-Te family; Ag-Sb-Ge-Te family; Si-Ge family; Fe-Si family; Mn-Si family; Zn-Sb family; chalcogenide; skutterudite; filled skutterudite; boron carbide; and layered cobalt oxide, can be used. The thermoelectric conversion element 2 is not limited to of n-type, and ones of p-type may be also used. Mg$_2$Si does not need to be of high purity, and it may be ones obtained by utilizing waste silicone sludge discharged at the time of grinding and polishing process, for example.

The more than one thermoelectric conversion element 2 of the first embodiment may be arranged between the substrates 11 and 12 and connected in series. For example, just like a thermoelectric conversion module 1 of the second embodiment shown in Figure 3, by using two thermoelectric conversion elements 2 and 2', second electrodes 31a and 31b are bonded to a connecting faces 21b and 21b of a joining / connecting part 21 of each of the two thermoelectric conversion elements 2 and 2', and first electrodes 32a and 32b are bonded to one ends 22a of pole-shaped parts 22 of each of the two thermoelectric conversion elements 2 and 2'. Then, the first electrode 32a bonded to the thermoelectric conversion element 2 and the second electrode 31b bonded to the thermoelectric conversion element 2' are electrically connected by a connecting part 33, and each of the electrodes 31a, 31b, 32a and 32b may be fixed to substrates 11 and 12. By composing in this way, the two thermoelectric conversion elements 2 and 2' are connected in series and thus more electric power can be obtained.

Also, any electrode material such as Ni, Al Cu, W, Au, Ag, Co, Mo, Cr, Ti, Pd or the like and alloys made from these, or transition metal silicide, TiN, AiTiN or the like can be used. Further, by arranging the more than one thermoelectric conversion element 2, it is possible to produce thermoelectric conversion modules of various sizes without changing a mold for forming the thermoelectric conversion element 2 according to the size of a thermoelectric conversion module and to reduce the production cost.

When the connecting part 33 is formed by the same material as that of the electrodes 32a and 31b, it may simply be formed thinly so as to suppress the transfer of heat The connecting part 33 may be made of a material with small thermal conductivity. In Figure 3, a heat-insulating material 5 arranged between the substrates 11 and 12 is omitted.

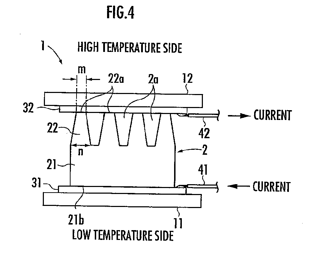

Like the third embodiment shown in Figure 4, the pole-shaped parts 22 of the thermoelectric conversion element 2 may be formed in a shape of a circular truncated cone or a truncated pyramid so that the area m of the one end 22a of each of the pole-shaped parts 22 is smaller than the section area n of the connecting portion in which the pole-shaped parts 22 and the joining / connecting part 21 are connected. By this, the area of the one end 22a of each of the pole-shaped parts 22 becomes further small, and thus absorption of heat in the high temperature side of the thermoelectric conversion element 2 is suppressed further and a temperature difference can be maintained more properly. In Figure 4, the heat-insulating material 5 arranged between the substrates 11 and 12 is also omitted.

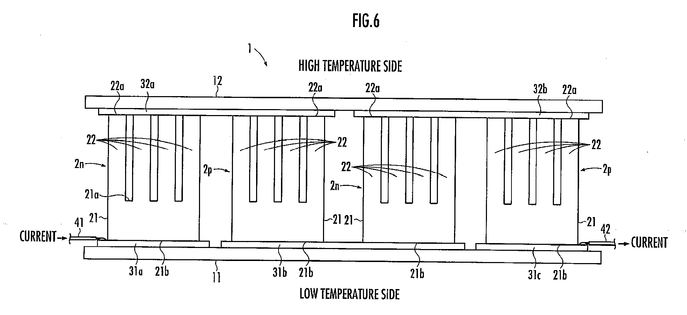

As is the case with the fourth embodiment shown in Figure 6, what is called a π-type thermoelectric conversion module 1 that has been known conventionally may be formed by: arranging an n-type thermoelectric conversion element 2n and a p-type thermoelectric conversion element 2p between the substrates 11 and 12 alternately; electrically connecting first electrodes 32a of the adjacent thermoelectric conversion elements 2n, 2p with each other; electrically connecting second electrodes 31b of each of adjacent thermoelectric conversion elements 2n, 2p in the side where first electrodes are separated with each other; and, by this, connecting each of the thermoelectric conversion elements 2n, 2p in series.

Although, in the first to third embodiments, the thermoelectric conversion element 2 used in the thermoelectric conversion module 1 for electric power generation using Seebeck effect has been described, a thermoelectric conversion element of the present invention can be also used in a thermoelectric conversion module that performs cooling and heating using Peltier effect.

Although, in the first to third embodiments, the one end 22a of each of the pole-shaped parts 22 ofthe thermoelectric conversion element 2 is bonded to the electrodes 32, 32a and 32b, it may be composed such that: the substrate 11 and the substrate 12 are joined by a heat-insulating member or the like so as to make a gap between the end 22a of each of the pole-shaped parts 22 and the electrodes 32, 32a and 32b to make the end 22a of each of the pole-shaped parts 22 and the electrodes 32, 32a and 32b be in a noncontact state; and, when the substrate 12 is heated, the end 22a of each of the pole-shaped parts 22 shifts to a state where it contacts with the electrodes 5, 53 and 54 by thermal expansion of the thermoelectric conversion element 2. By this, because, in a noncontact state, there are no cases that a force is applied from the side of the one end 22a of each of the pole-shaped parts 22 of the thermoelectric conversion element 2, and durability of the thermoelectric conversion module 2 can be improved.

Any heat-insulating material such as mica (isinglass), a silicate calcium board, glass fiber, rock wool, slag wool, ceramic fiber, wollastonite, xonotlite, asbestos, sepiolite, palygorskite, potassium titanate, basic magnesium sulfate, a fine-grained silicate pulverulent body, silicic acid anhydride (aerosil), hydrated silicic acid (white carbon), diatom earth, tobermorite, mullite balloon, whitebait balloon, glass balloon, perlite, fly ash, compound materials containing these and the like can be used, for example.

A bonding layer may be provided on the connecting face 21b of the joining / connecting part 21 of the thermoelectric conversion element 2 and the one end 22a of each of the pole-shaped parts 22 in order to reduce a contact resistance against an electrode. Such a bonding layer is preferably formed by nickel, aluminum, copper, zinc or alloys of combinations of these, or may be formed by other materials.

When forming a bonding layer, a columnar-shaped sintered body having bonding layers in the both ends may simply be formed in a manner that: nickel in powder form (average particle diameter of about 63 $\mu$m) is fed into the through-hole D1 of the mold D, the lower opening of the hole D1 being closed by the punch P1; after hardening it by pressing the punch P2, $Mg_2Si$ in powder form is fed into the through-hole D 1; nickel in powder form is fed into the through-hole D1 again after that, and pressed again by the punch P2; and, finally, a sintering processing is performed, for example. Alternatively, a bonding layer may be formed by plating.

**Claims**

1. A thermoelectric conversion element, arranged between a first electrode and a second electrode of a thermoelectric conversion module comprising the first electrode and the second electrode arranged at an interval from each other, and electrically connecting the first electrode and the second electrode, comprising:

   a plurality of pole-shaped parts, the pole-shaped parts being arranged at an interval from each other, and one end of each of the pole-shaped parts being electrically connected to the first electrode; and
   a joining / connecting part joining / connecting other ends of the pole-shaped parts together and electrically connected to the second electrode, wherein
   a connecting face of the joining / connecting part, the face being connected to the second electrode, is larger than a sum total of areas of one ends of the respective pole-shaped parts.

2. The thermoelectric conversion element according to claim 1, wherein an area of the one ends of the respective pole-shaped parts is smaller than a section area of a connecting portion between each of the pole-shaped parts and the joining / connecting part.

3. A thermoelectric conversion module, comprising a plurality of thermoelectric conversion elements according to claim 1 or claim 2 arranged between a pair of substrates in a state of being electrically connected to the first electrode and the second electrode, and all of the thermoelectric conversion elements being formed as n-type or p-type, wherein the first electrode connected to one thermoelectric conversion element is electrically connected to the second electrode connected to an adjacent thermoelectric conversion element to connect each of the thermoelectric conversion elements in series.

4.  A thermoelectric conversion module, comprising a plurality of thermoelectric conversion elements according to claim 1 or claim 2, the thermoelectric conversion elements being formed as n-type and p-type, and arranged between a pair of substrates in a state of each of the thermoelectric conversion elements being connected to the first electrode and the second electrode in a manner that n-type thermoelectric conversion elements and p-type thermoelectric conversion elements are positioned alternately, wherein the first electrodes of two adjacent thermoelectric conversion elements are electrically connected to each other, and the second electrodes of the two adjacent thermoelectric conversion elements having the first electrodes separated from each other are electrically connected to each other, resulting in each of the thermoelectric conversion elements being connected in series.

5.  A thermoelectric conversion module, comprising a thermoelectric conversion element according to claim 1 or claim 2 arranged between a pair of substrates in a state of being electrically connected to the first electrode and the second electrode, wherein a heat-insulating material is arranged between the pair of substrates.

FIG.1

FIG.2

FIG.3

1

HIGH TEMPERATURE SIDE

22a  32a                    12  32b  22a

42

CURRENT

22                                    22

2                          33          2'

CURRENT  41  21                        21

31a  21b        11  31b  21b

LOW TEMPERATURE SIDE

13

EP 2 405 502 A1

## FIG.4

HIGH TEMPERATURE SIDE

LOW TEMPERATURE SIDE

14

## FIG.5 (a)

HIGH TEMPERATURE SIDE

32   $S_1$   22a   12

21b   31   $S_2$   11

LOW TEMPERATURE SIDE

## FIG.5 (b)

HIGH TEMPERATURE SIDE

32   $S_1$   12

素子

31   $S_1$   11

LOW TEMPERATURE SIDE

FIG.6

FIG.7 (a)                    FIG.7 (b)

FIG.8 (a)　　　　　　　　　　FIG.8 (b)

FIG.9

FIG.10

FIG.11

FIG.12

FIG.13

FIG.14

FIG.15

FIG.16

## INTERNATIONAL SEARCH REPORT

| International application No. |
| --- |
| PCT/JP2010/052824 |

A. CLASSIFICATION OF SUBJECT MATTER
*H01L35/32*(2006.01)i, *H01L35/08*(2006.01)i, *H01L35/14*(2006.01)i, *H01L35/34*
(2006.01)i, *H02N11/00*(2006.01)i

According to International Patent Classification (IPC) or to both national classification and IPC

B. FIELDS SEARCHED

Minimum documentation searched (classification system followed by classification symbols)
H01L35/32, H01L35/08, H01L35/14, H01L35/34, H02N11/00

Documentation searched other than minimum documentation to the extent that such documents are included in the fields searched
| | | | |
| --- | --- | --- | --- |
| Jitsuyo Shinan Koho | 1922–1996 | Jitsuyo Shinan Toroku Koho | 1996–2010 |
| Kokai Jitsuyo Shinan Koho | 1971–2010 | Toroku Jitsuyo Shinan Koho | 1994–2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>Y<br>A | JP 2001-320096 A (Citizen Watch Co., Ltd.),<br>16 November 2001 (16.11.2001),<br>paragraphs [0008] to [0026]; fig. 1 to 8<br>(Family: none) | 1,2<br>3,5<br>4 |
| Y | JP 2004-311819 A (Idemitsu Kosan Co., Ltd.),<br>04 November 2004 (04.11.2004),<br>paragraphs [0012] to [0017]; fig. 1<br>(Family: none) | 3 |
| Y | JP 11-220184 A (Director-General of National<br>Aerospace Laboratory of Science and Technology<br>Agency),<br>10 August 1999 (10.08.1999),<br>claim 6; paragraph [0037]; fig. 4<br>(Family: none) | 5 |

☒ Further documents are listed in the continuation of Box C. ☐ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 18 May, 2010 (18.05.10) | 01 June, 2010 (01.06.10) |

| Name and mailing address of the ISA/<br>Japanese Patent Office | Authorized officer |
| --- | --- |
| Facsimile No. | Telephone No. |

Form PCT/ISA/210 (second sheet) (July 2009)

**INTERNATIONAL SEARCH REPORT**

International application No.

PCT/JP2010/052824

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2002-285274 A  (Daido Steel Co., Ltd.), 03 October 2002 (03.10.2002), entire text (Family: none) | 1-5 |
| A | JP 11-274578 A  (Matsushita Electric Industrial Co., Ltd.), 08 October 1999 (08.10.1999), entire text; all drawings (Family: none) | 1-5 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11274578 A